# EUROPEAN PATENT APPLICATION

(11) **EP 2 587 485 A1**
(43) Date of publication of application: **01.05.2013**
(21) Application number: 12187555.3
(22) Date of filing: 08.10.2012
(51) Int. Cl.: G11C 7/10, G11C 8/16, G06F 5/16

(54) **A dual-port memory and a method thereof**

(30) Priority: 24.10.2011 CN 201110325418; 25.09.2012 US 201213626013
(71) Applicant: Maishi Electronic (Shanghai) Ltd., Zhang Jiang Hi-Tech Park Shanghai 201203 (CN)
(72) Inventor: Zhang, Weihua, 610041 Chengdu (CN); Yu, Mei, 610041 Chengdu (CN)
(74) Representative: Lippert, Stachow & Partner

(57) **Abstract**

A dual-port memory (200, 300) is provided. The dual-port memory includes a first single-port memory (202, 302) and a second single-port memory (201, 301). The first single-port memory is configured to store data in an even address of the dual-port memory. The second single-port memory is configured to store data in an odd address of the dual-port memory. The dual-port memory simultaneously performs a read operation to read data from the odd address and a write operation to write data into the even address in a first operation cycle. The dual-port memory thensimultaneously performs a read operation to read data from the even address and a write operation to write data into the odd address in a second operation cycle. The two operation cycles repeat alternately.

## Description

### RELATED APPLICATION

This Application claims priority to Chinese Patent Application Number 201110325418.6, filed on October, 24, 2011 with State Intellectual Property Office of P.R. China (SIPO), which is hereby incorporated by reference.

### FIELD OF THE PRESENT TEACHING

The present teaching relates to memories, and more particularly to a dual-port memory and a method thereof.

### BACKGROUND

Memories may be classified into single-port memories and dual-port memories according to the way in which data is accessed. Compared with single-port memories, dual-port memories can read and write data at a high speed as they have separate read and write control circuits, and thus, are widely used in computer related fields. For example, dual-port memories, such as a dual-port random access memory (RAM) and a first input first output (FIFO), can be used for communication between a host and an external device and for communication among the hosts. However, as dual-port memories have separate read and write control circuits, they occupy relatively large die sizes, thereby increasing the manufacturing costs of circuit components having those dual-port memories.

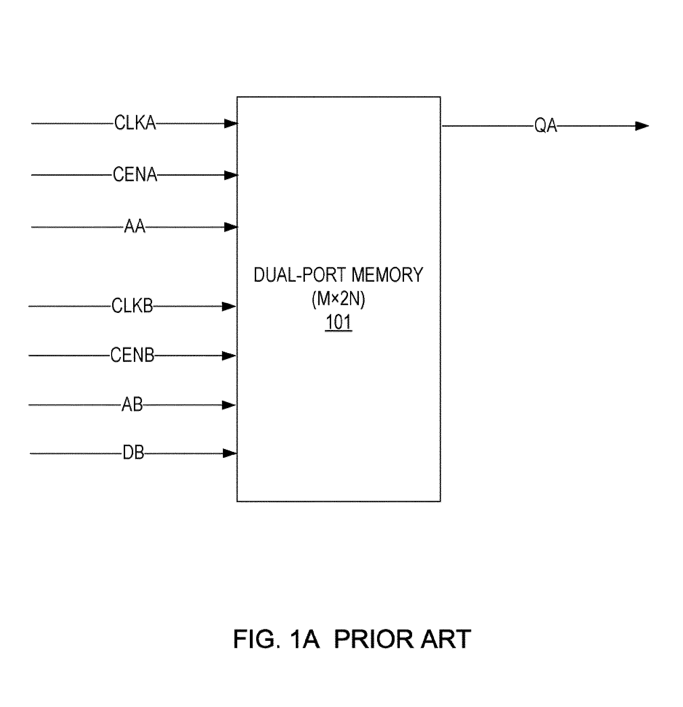

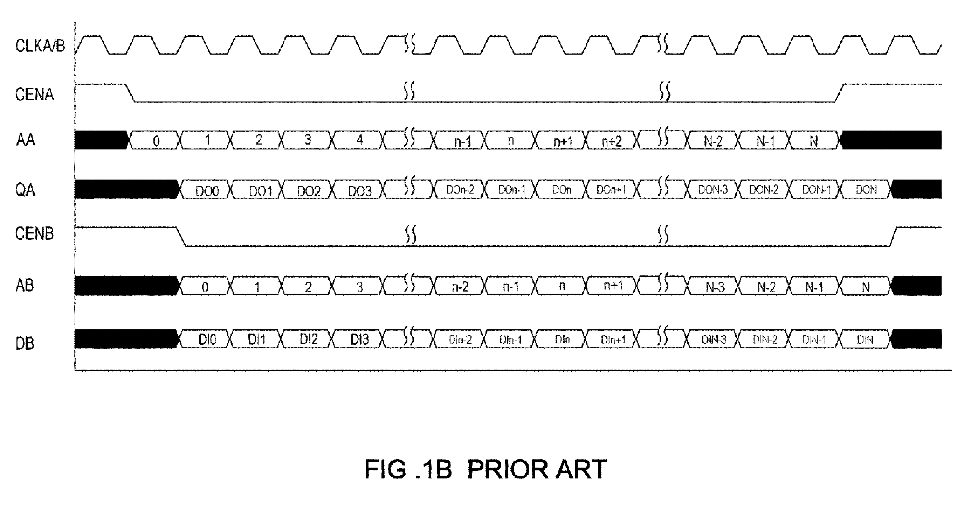

FIG. 1A is a block diagram of a prior art dual-port memory 101 with a capacity of M × 2N. FIG. 1B shows a timing diagram of signals associated with the dual-port memory 101 in FIG. 1A. FIG. 1A is described in combination with FIG. 1B. As shown in FIG. 1A, the dual-port memory 101 includes a read operation clock signal terminal CLKA, a read operation enable signal terminal CENA, a read operation address input terminal AA, a read operation data output terminal QA, a write operation clock signal terminal CLKB, a write operation enable signal terminal CENB, a write operation address input terminal AB, and a write operation data input terminal DB.

As shown in FIG. 1B, when reading data from the dual-port memory 101, the read operation enable signal terminal CENA is at a logic low state, the read address is input through the read operation address input terminal AA, and the data at the read address is output via the read operation data output terminal QA during the next clock cycle. When writing data into the dual-port memory 101, the write operation enable signal terminal CENB is at a logic low state, the write address is input through the write operation address input terminal AB, and the data is written into the write address through the write operation data input terminal DB. As shown in FIG. 1B, the read operation and the write operation can be performed simultaneously in the dual-port memory 101 to increase the access rate. However, the die size of the dual-port memory 101 is relatively large; therefore, the cost for manufacturing the dual-port memory 101 is relatively high.

### SUMMARY

The present teaching relates to memories, and more particularly to a dual-port memory and a method thereof.

In one example, a dual-port memory including a first single-port memory and a second single-port memory is provided. The first single-port memory is configured to store data in an even address of the dual-port memory. The second single-port memory is configured to store data in an odd address of the dual-port memory. The dual-port memory simultaneously performs a read operation to read data from the odd address and a write operation to write data into the even address. The dual-port memory simultaneously performs a read operation to read data from the even address and a write operation to write data into the odd address simultaneously.

In another example, a method of utilizing a dual-port memory is provided. Data at an even address of a dual-port memory is stored into a first single-port memory. Data at an odd address of the dual-port memory is stored into a second single-port memory. The first single-port memory and the second single-port memory are enabled by a first pair of multiplexers. A write enable signal is provided to a selected single-port memory of the first single-port memory and the second single-port memory by a second pair of multiplexers to enable the selected single-port memory to perform a write operation. A write address is provided to the selected single-port memory by a third pair of multiplexers to enable the selected single-port memory to write data into the write address.

### BRIEF DESCRIPTION OF THE DRAWINGS

Features and advantages of embodiments of the claimed subject matter will become apparent as the following detailed description proceeds, and upon reference to the drawings, wherein like numerals depict like parts. These exemplary embodiments are described in detail with reference to the drawings. These embodiments are non-limiting exemplary embodiments, in which like reference numerals represent similar structures throughout the several views of the drawings.

FIG. 1A shows a block diagram of a prior art dual-port memory;

FIG. 1B shows a timing diagram of signals associated with the dual-port memory in FIG. 1A;

FIG. 2 shows a block diagram of a dual-port memory in accordance with one embodiment of the present teaching;

FIG. 3 shows a detailed block diagram of a dual-port memory in accordance with one embodiment of the present teaching;

FIG. 3A shows a block diagram of a single-port memory in FIG. 3;

FIG. 4A-4D show block diagrams of selection signal generating circuits for multiplexers in the dual-port memory, in accordance with one embodiment of the present teaching;

FIG. 5 shows a timing diagram of signals associated with the dual-port memory in FIG. 3 in accordance with one embodiment of the present teaching; and

FIG. 6 shows a flowchart of operations performed by a dual-port memory, in accordance with one embodiment of the present teaching.

### DETAILED DESCRIPTION

Reference will now be made in detail to the embodiments of the present teaching. While the present teaching will be described in conjunction with these embodiments, it will be understood that they are not intended to limit the present teaching to these embodiments. On the contrary, the present teaching is intended to cover alternatives, modifications and equivalents, which may be included within the spirit and scope of the present teaching as defined by the appended claims.

Furthermore, in the following detailed description of the present teaching, numerous specific details are set forth in order to provide a thorough understanding of the present teaching. However, it will be recognized by one of ordinary skill in the art that the present teaching may be practiced without these specific details. In other instances, well known methods, procedures, components, and circuits have not been described in detail as not to unnecessarily obscure aspects of the present teaching.

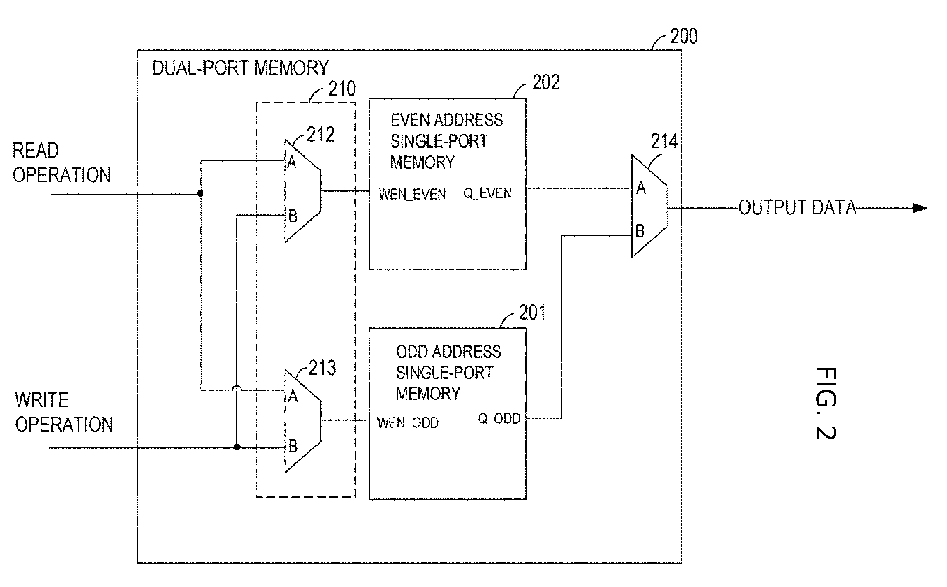

FIG. 2 shows a block diagram of a dual-port memory 200 in accordance with one embodiment of the present teaching. The dual-port memory 200 includes an odd address single-port memory 201 with a capacity of M×N for storing data at the odd addresses of the dual-port memory 200, an even address single-port memory 202 with a capacity of M×N for storing data at the even addresses of the dual-port memory 200, a multiplexer 212 coupled to the even address single-port memory 202, a multiplexer 213 coupled to the odd address single-port memory 201, and a multiplexer 214 for outputting data.

In this example, the addresses of the dual-port memory 200 are classified into even addresses and odd addresses. The even address single-port memory 202 stores data at the even addresses, and the odd address single-port memory 201 stores data at the odd addresses. In operation, when the data at an even address of the dual-port memory 200 is to be read, the even address single-port memory 202 receives the even address via the multiplexer 212 and performs the read operation to read data at the even address and simultaneously, the odd address single-port memory 201 receives an odd address of the dual-port memory 200 via the multiplexer 213 and performs the write operation to write data at the odd address. On the other hand, when the data at an odd address of the dual-port memory 200 is to be read, the odd address single-port memory 201 receives the odd address via the multiplexer 213 and performs the read operation to read data at the odd address, and simultaneously, the even address single-port memory 202 receives an even address of the dual-port memory 200 via the multiplexer 212 and performs the write operation to write data at the even address.

The total size of the even address single-port memory 202 and the odd address single-port memory 201 is smaller than the size of the prior art dual-port memory, and thus, the cost of manufacturing the dual-port memory is decreased.

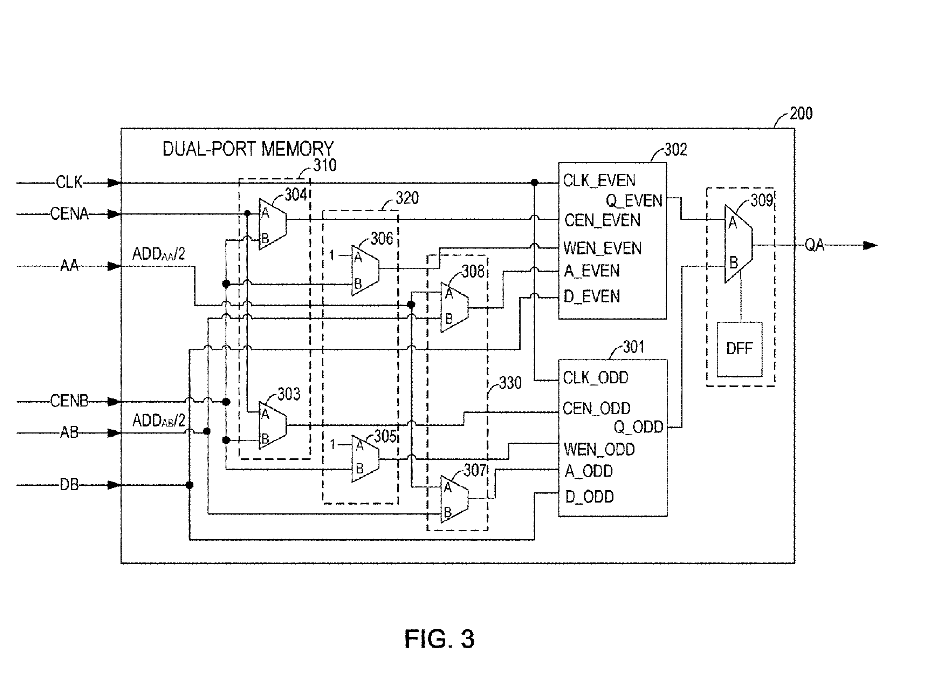

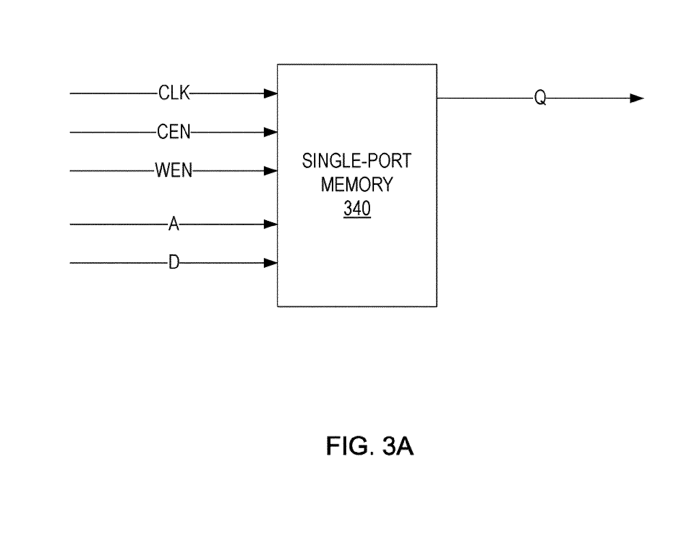

FIG. 3 shows a detailed block diagram of a dual-port memory 200 in accordance with one embodiment of the present teaching. The dual-port memory 200 in this example includes an odd address single-port memory 301 configured to store data at the odd addresses of the dual-port memory 200 and an even address single-port memory 302 configured to store data at the even addresses of the dual-port memory 200.

The dual-port memory 200 in this example includes multiple terminals, for example, a clock signal terminal CLK, a read operation enable signal terminal CENA, a read operation address input terminal AA, a write operation enable signal terminal CENB, a write operation address input terminal AB, a write operation data input terminal DB, and a data output terminal QA. Each of the single-port memories 301 and 302 includes multiple terminals which will be illustrated in detail in combination with FIG. 3A. The relationship between the terminals of the internal odd address single-port memory 201 and the internal even address single-port memory 202 and the external terminals of the dual-port memory 200 will be illustrated below.

FIG. 3A shows a block diagram of a single-port memory in FIG. 3. The single-port memory 340 in this example includes a clock signal terminal CLK, a chip enable signal terminal CEN, a write enable signal terminal WEN, a read/write address input terminal A, a write data input terminal D and a data output terminal Q. When reading data from the single-port memory 340 or writing data into the single-port memory 340, the chip enable signal terminal CEN is at a logic low state. When reading data from the single-port memory 340, the address is input through the read/write address input terminal A, and the data may be output via the data output terminal Q during the next clock cycle. When writing data into the single-port memory 340, the write enable signal terminal WEN is at a logic low state, the address is input through the read/write address input terminal A, and the data is written into the address via the data input terminal D.

Referring to FIG. 3, in this example, the clock signal terminal CLK of the dual-port memory 200 is coupled to the clock signal terminal CLK_EVEN of the even address single-port memory 302 and the clock signal terminal CLK_ODD of the odd address single-port memory 301. The write operation data input terminal DB of the dual-port memory 200 is coupled to the write data input terminal D_EVEN of the even address single-port memory 302 and the write data input terminal D_ODD of the odd address single-port memory 301.

The dual-port memory 200 in this example includes a first pair of multiplexers 310 configured to provide an enable signal to the chip enable signal terminal CEN_EVEN of the even address single-port memory 302 and the chip enable signal terminal CEN_ODD of the odd address single-port memory 301 by selecting an external read operation enable signal R_EN or an external write operation enable signal W_EN of the dual-port memory 200.

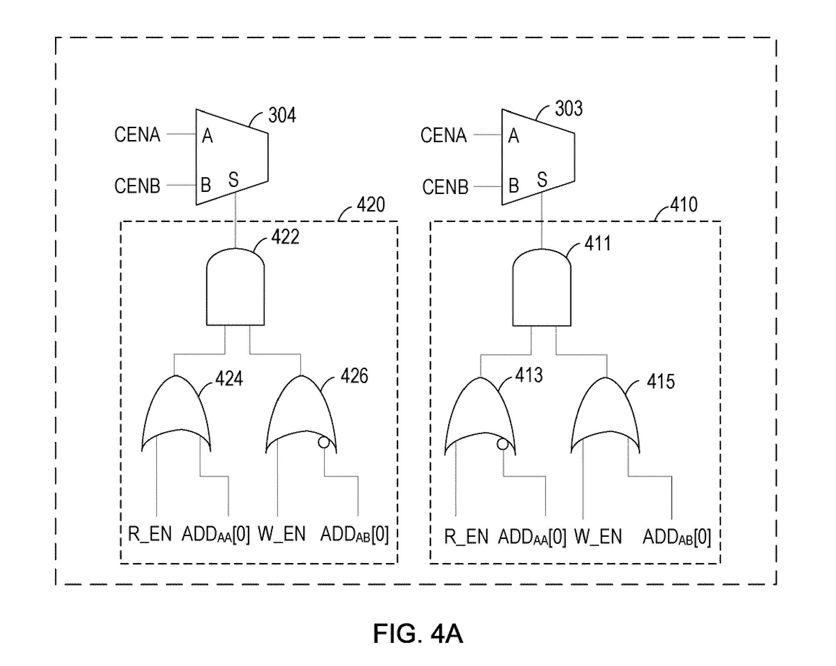

In this example, the first pair of multiplexers 310 include a first multiplexer 304 and a second multiplexer 303. An input terminal A of the first multiplexer 304 is coupled to the read operation enable signal terminal CENA to receive the external read operation enable signal R_EN, and another input terminal B of the first multiplexer 304 is coupled to the write operation enable signal terminal CENB to receive the external write operation enable signal W_EN. The selection signal of the first multiplexer 304 will be described below in combination with FIG. 4A. Thus, the first multiplexer 304 provides the enable signal to the chip enable signal terminal CEN_EVEN of the even address single-port memory 302 by selecting the external read operation enable signal R_EN or the external write operation enable signal W_EN. An input terminal A of the second multiplexer 303 is coupled to the read operation enable signal terminal CENA, and another input terminal B of the second multiplexer 303 is coupled to the write operation enable signal terminal CENB. The selection signal of the second multiplexer 303 will be described below in combination with FIG. 4A. Thus, the second multiplexer 303 provides the enable signal to the chip enable signal terminal CEN_ODD of the odd address single-port memory 301 by selecting the external read operation enable signal R_EN or the external write operation enable signal W_EN. Therefore, for each single-port memory, whether performing a read operation or a write operation, the corresponding chip enable signal terminal is always enabled.

In this example, the dual-port memory 200 further includes a second pair of multiplexers 320 configured to provide a write enable signal to the write enable signal terminal WEN_EVEN of the even address single-port memory 302 and the write enable signal terminal WEN_ODD of the odd address single-port memory 301 by selecting the external write operation enable signal W_EN and a signal mask, for example, digital one.

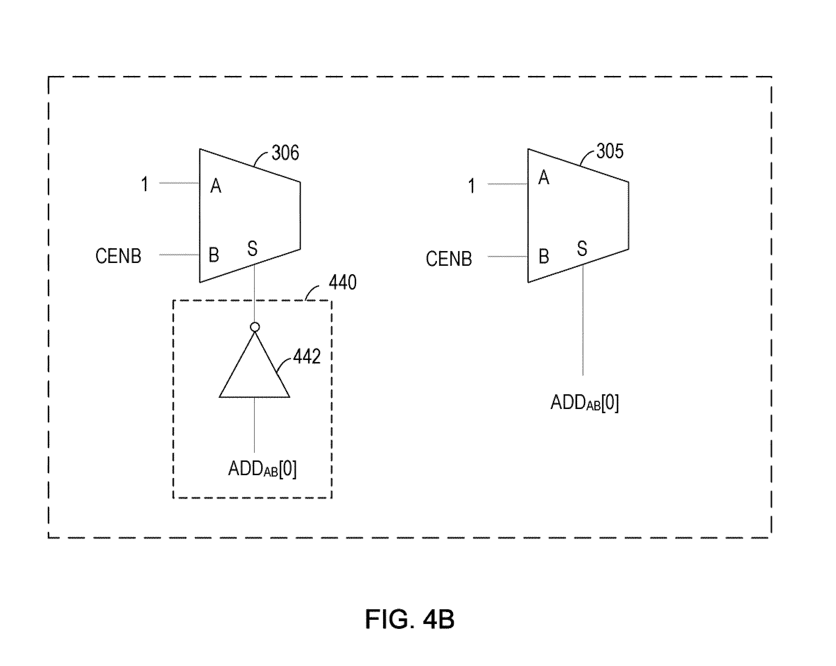

In this example, the second pair of multiplexers 320 include a third multiplexer 306 and a fourth multiplexer 305. An input terminal A of the third multiplexer 306 receives the signal mask (digital one), and another input terminal B of the third multiplexer 305 is coupled to the write operation enable signal terminal CENB to receive the external write operation enable signal W_EN. The selection signal of the third multiplexer 306 will be described below in combination with FIG. 4B. Thus, the third multiplexer 306 provides the write enable signal to the write enable signal terminal WEN_EVEN of the even address single-port memory 302 by selecting the external write operation enable signal W_EN or signal mask. An input terminal A of the fourth multiplexer 305 is coupled to the signal mask (digital one), and another input terminal B of the fourth multiplexer 305 is coupled to the write operation enable signal terminal CENB. The selection signal of the fourth multiplexer 305 will be described below in combination with FIG. 4B. Thus, the fourth multiplexer 305 provides the write enable signal to the write enable signal terminal WEN_ODD of the odd address single-port memory 301 by selecting the external write operation enable signal W_EN or the signal mask.

Therefore, for each single-port memory, when performing write operation, the corresponding write enable signal terminal is enabled by receiving the external write operation enable signal W_EN via the corresponding multiplexer. Otherwise, the corresponding write enable signal terminal is disabled by the signal mask (digital one).

In this example, the dual-port memory 200 further includes a third pair of multiplexers 330 configured to provide a read/write address to the even address single-port memory 302 and the odd address single-port memory 301 based on an external read address ADD_{AA} or an external write address ADD_{AB}.

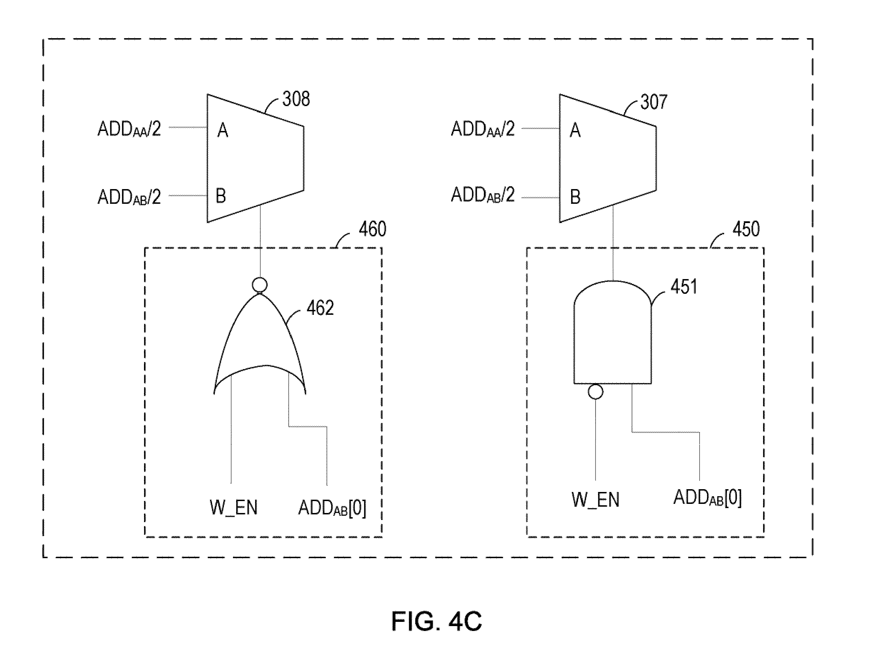

In this example, the third pair of multiplexers 310 include a fifth multiplexer 308 and a sixth multiplexer 307. An input terminal A of the fifth multiplexer 308 is coupled to the read operation address input terminal AA to receive a first address (ADD_{AA}/2) which is the quotient of the external read address ADD_{AA} divided by two, and another input terminal B of the fifth multiplexer 308 is coupled to the write operation address input terminal AB to receive a second address (ADD_{AB}/2) which is the quotient of the external write address ADD_{AB} divided by two. The selection signal of the fifth multiplexer 308 will be described below in combination with FIG. 4C. Thus, the fifth multiplexer 308 provides the read/write address to the even address single-port memory 302 by selecting the first address or the second address. An input terminal A of the sixth multiplexer 307 is coupled to the read operation address input terminal AA to receive the first address, and another input terminal B of the sixth multiplexer 307 is coupled to the write operation address input terminal AB to receive the second address. The selection signal of the sixth multiplexer 307 will be described below in combination with FIG. 4C. Thus, the sixth multiplexer 307 provides the write/read address to the odd address single-port memory 301 by selecting the first address (ADD_{AA}/2) or the second address (ADD_{AB}/2).

Therefore, for each single-port memory, when performing read operation, the corresponding read/write address input terminal receives the first address (ADD_{AA}/2) which is the quotient of the external read address divided by two via the third pair of the multiplexers 330. When performing write operation, the corresponding read/write address input terminal A receives the second address (ADD_{AB}/2) which is the quotient of the external write address divided by two via the third pair of the multiplexers 330.

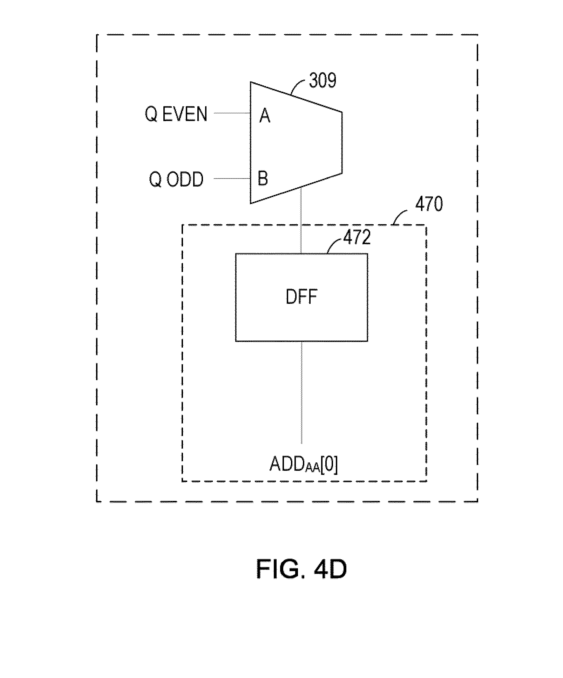

In this example, the dual-port memory 200 further includes an output multiplexer 309 coupled to the data output terminals Q_EVEN and Q_ODD of the even address single-port memory 302 and the odd address single-port memory 301. The output multiplexer 309 is configured to output data read from the even address single-port memory 302 and the odd address single-port memory 301. The selection signal of the output multiplexer 309 will be described below in combination with FIG. 4D.

In this example, an input terminal A of the output multiplexer 309 is coupled to the even address single-port memory 302 and another input terminal B is coupled to the odd address single-port memory 301, and the data output terminal QA outputs the data read from the even address single-port memory 302 and the odd address single-port memory 301. When the even address single-port memory 302 performs a read operation, the output multiplexer 309 selects data at the data output terminal Q_EVEN and outputs the data via the data output terminal QA. When the odd address single-port memory 301 performs a read operation, the output multiplexer 309 selects data at the data output terminal Q_ODD of the odd address single-port memory 301 and outputs the data via the data output terminal QA.

In this example, the selection signals of the foregoing multiplexers 303-308 are determined by the parity of the external read address ADD_{AA} and the external write address ADD_{AB}. For example, the selection signals may be determined by a logical operation on the least significant bit (LSB) of the external read address ADD_{AA} and the least significant bit (LSB) of the external write address ADD_{AB}. In one embodiment, if the selection signal is in a first state, for example, logic high, the signal at the terminal B of a multiplexer is selected; if the selection signal is in a second state, for example, logic low, the signal at the terminal A of a multiplexer is selected.

In one embodiment, when the read operation and the write operation are performed simultaneously, the selection signals in each pair of the multiplexers are opposite to each other. For example, when writing data into the even address and reading data from the odd address, the selection signal of the first multiplexer 304 is in a first state, for example, logic high, and thus, the external write operation enable signal W_EN at the input terminal B of the multiplexer 304 is selected and output to the terminal CEN_EVEN to enable the even address single-port memory 302. Simultaneously, the selection signal of the second multiplexer 303 is in a second state, for example, logic low, and thus, the external read operation enable signal R_EN at the input terminal A of the second multiplexer 303 is selected and output to the terminal CEN_ODD to enable the odd address single-port memory 301.

FIG. 4A shows block diagrams of selection signal generating circuits 410 and 420 for the first pair of multiplexers 310 of the dual-port memory 200, in accordance with one embodiment of the present teaching. In this example, the first selection signal generating circuit 420 includes an OR gate 424 configured to receive the external read operation enable signal R_EN and the least significant bit (ADD_{AA}[0]) of the external read address ADD_{AA}, an OR gate 426 configured to receive the external write operation enable signal W_EN and the least significant bit (ADD_{AB}[0]) of the external write address ADD_{AB}, and an AND gate 422 configured to receive outputs of the OR gates 424 and 426 and provide an output signal as the selection signal to the first multiplexer 304.

Similarly, the second selection signal generating circuit 410 includes an OR gate 413 configured to receive the external read operation enable signal R_EN and the least significant bit (ADD_{AA}[0]) of the external read address ADD_{AA}, an OR gate 415 configured to receive the external write operation enable signal W_EN and the least significant bit (ADD_{AB}[0]) of the external write address ADD_{AB}, and an AND gate 411 configured to receive outputs of the OR gates 413 and 415 and provide an output signal as the selection signal to the second multiplexer 303.

FIG. 4B shows a block diagram of a selection signal generating circuit 440 for the second pair of multiplexers 320 of the dual-port memory 200, in accordance with one embodiment of the present teaching. As shown in the example of FIG. 4B, the selection signal generating circuit 440 for the third multiplexer 306 includes a NOT gate 442 configured to receive the least significant bit (ADD_{AB}[0]) of the external write address ADD_{AB} and output a reverse signal of ADD_{AB}[0] as the selection signal to the third multiplexer 306. The selection terminal S of the fourth multiplexer 305 receives the least significant bit (ADD_{AB}[0]) of the external write address ADD_{AB} as the selection signal.

FIG. 4C shows block diagrams of selection signal generating circuits 450 and 460 for the third pair of multiplexers 330 of the dual-port memory 200, in accordance with one embodiment of the present teaching. As shown in the example of FIG. 4C, the selection signal generating circuit 460 for the fifth multiplexer 308 includes a NOR gate 462 configured to receive the external write operation enable signal W_EN and the least significant bit (ADD_{AB}[0]) of the external write address ADD_{AB}, and provide an output as the selection signal to the fifth multiplexer 308. The selection signal generating circuit 450 for the sixth multiplexer 307 includes an AND gate 451 configured to receive the external write operation enable signal W_EN and the least significant bit (ADD_{AB}[0]) of the external write address ADD_{AB}, and provide an output as the selection signal to the sixth multiplexer 307.

The selection signal of the output multiplexer 309 may be determined by the parity of the external read address ADD_{AA}. FIG. 4D shows a block diagram of a selection signal generating circuit 470 for the output multiplexer 309. In one embodiment, the selection signal generating circuit 470 includes a D flip-flop (DFF) 472 configured to receive the least significant bit (ADD_{AA}[0]) of the external read address ADD_{AA} and provide an output signal during the next clock cycle as the selection signal to the multiplexer 309. It should be understood that other types of flip-flop may also be used to generate the selection signal for the output multiplexer 309.

For example, if the external read address ADD_{AA} is odd, for example, [00000011], the least significant bit ADD_{AA}[0] is 1, and the selection signal of the multiplexer 309 is digital one, then the data at the terminal B of the multiplexer 309 is selected, and, the data read from the odd address single-port memory 301 is output via the terminal QA. If the external read address is even, for example, [00000010], the least significant bit ADD_{AA}[0] is 0, and the selection signal of the multiplexer 309 is zero, then the data at the terminal A of the multiplexer 309 is selected, and, the data read from the even address single-port memory 302 is output via the terminal QA.

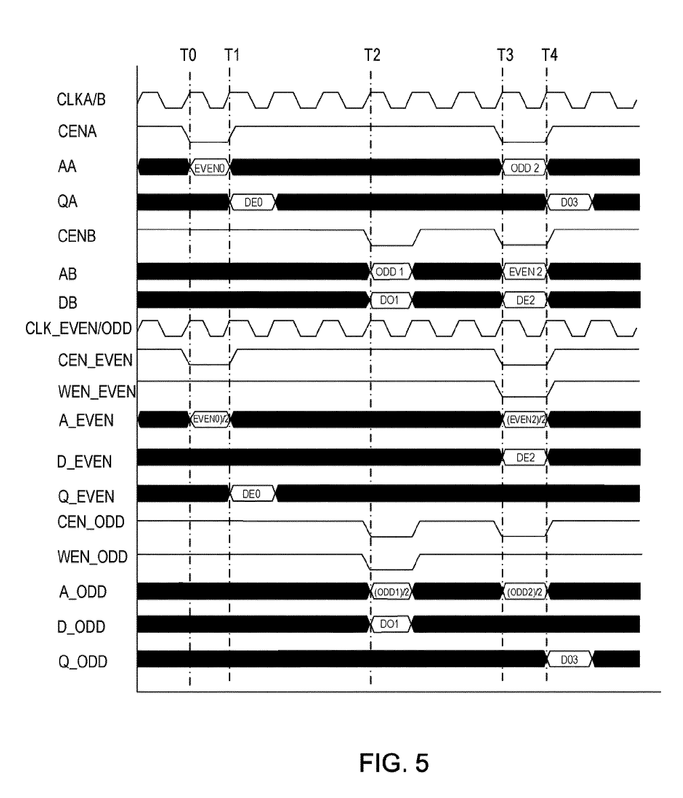

FIG. 5 shows a timing diagram of signals associated with the dual-port memory in FIG. 3 in accordance with one embodiment of the present teaching. The operations of the dual-port memory 200 of the present teaching will be illustrated in combination with FIG. 3, FIG. 4A-4D and FIG. 5.

As shown in FIG. 5, the odd address single-port memory 301 and the even address single-port memory 302 may operate using the same external clock. The odd address single-port memory 301 operates when reading data from or writing data into an odd address of the dual-port memory 200, and the even address single-port memory 302 operates when reading data from or writing data into an even address of the dual-port memory 200. Moreover, the dual-port memory 200 in this example may also perform read operation on an address and write operation on another address with opposite parity simultaneously.

In one embodiment, when the external read operation enable signal R_EN becomes low, the external write operation signal W_EN becomes high, and the address input via the terminal AA is even, the even address single-port memory 302 in the dual-port memory 200 is enabled and performs the read operation on the even address of the dual-port memory 200.

As shown in the example of FIG. 5, at time T0, the external read operation enable signal R_EN at the read operation enable signal terminal CENA is low, and an even external read address ADD_{AA} is input via the terminal AA. Thus, the least significant bit ADD_{AA}[0] is digital zero. Referring to FIG. 4A, the output of the OR gate 424 becomes low. The write operation enable signal W_EN at the write operation enable signal terminal CENB is high, the output of the OR gate 426 becomes high, and the output of the AND 422 gate becomes low. Thus, the selection signal of the first multiplexer 304 becomes low, which selects the external read operation enable signal R_EN (which is low) at the terminal A to output to the even address single-port memory 302. Therefore, the even address single-port memory 302 is enabled as the signal at the terminal CEN_EVEN becomes low.

Referring to the selection signal generating circuit 410 in FIG. 4A, the outputs of the OR gates 413 and 415 are high, therefore the output of the AND gate 411 becomes high. The selection signal of the multiplexer 303 becomes high and selects the external write operation enable signal W_EN (which is high) at the terminal B to output to the odd address single-port memory 301. The odd address single-port memory 301 is disabled as the signal at the terminal CEN_ODD becomes high.

At time T0, the external write address ADD_{AB} at the write operation address input terminal AB is invalid, and the external write operation enable signal W_EN at the write operation enable signal terminal CENB is high. According to the example shown in FIG. 4B, the inputs of the multiplexer 306 are both logic high. Regardless of whether the least significant bit ADD_{AB}[0] is digital one or digital zero, the output of the multiplexer 306 becomes high and is sent to the write enable signal terminal WEN_EVEN of the even address single-port memory 302 to disable the write operation of the even address single-port memory 302.

Referring to FIG. 4C, as the external write operation enable signal W_EN at the write operation enable signal terminal CENB is high at time T0, the output of the NOR gate 462 is low, and thus, the selection signal for the multiplexer 308 is low. Therefore, the first address (ADD_{AA}/2), which is the quotient of the external read address ADD_{AA} divided by two, at the terminal A of the multiplexer 308 is selected and sent to the read/write address input terminal A_EVEN of the even address single-port memory 302. Thus, the even address single-port memory 302 in the dual-port memory 200 is enabled and performs the read operation on the even address of the dual-port memory 200.

The output multiplexer 309 outputs the data read from the even address of the dual-port memory 200 in accordance with the selection signal provided by the DFF 472. Referring to FIG. 4D, as the external read address ADD_{AA} is even, the least significant bit ADD_{AA}[0] is digital zero, and the DFF 472 outputs digital zero during the next clock cycle. Therefore, the data at the terminal A of the output multiplexer 309 is selected and output via the data output terminal QA at time T1.

Similarly, a read operation may also be performed on the odd address of the dual-port memory 200. The read operation performed on the odd address of the dual-port memory 200 is similar to the read operation performed on the even address and will not be repetitively described for purposes of brevity and clarity.

In one embodiment, when the write operation enable signal W_EN becomes low, the read operation signal R_EN becomes high, and the address input via the terminal AB is odd, the odd address single-port memory 301 in the dual-port memory 200 is enabled and performs the write operation on the odd address of the dual-port memory 200.

As shown in the example of FIG. 5, at time T2, the external write operation enable signal W_EN at the write operation enable signal terminal CENB is low, the external read operation enable signal R_EN is high, and an odd address ADD_{AB} is input via the terminal AB. Thus, the least significant bit ADD_{AB}[0] is digital one. Referring to FIG. 4A, the output of the OR gate 413 is high, the output of the OR gate 415 is high, and the output of the AND gate 411 is high. Thus, the selection signal of the second multiplexer 303 is high, which selects the external write operation enable signal W_EN (which is low) at the terminal B of the multiplexer 303 to output to the odd address single-port memory 301. Therefore, the odd address single-port odd 301 is enabled as the signal at the terminal CEN_ODD is low.

Referring to the selection signal generating circuit 420 in FIG. 4A, the outputs of the OR gates 424 and 426 are high and low, respectively, then the output of the AND gate 422 is low. Therefore, the selection signal of the multiplexer 304 becomes low, and the external read operation enable signal R_EN (which is logic high) at the terminal A of the multiplexer 304 is selected and output to the even address single-port memory 302. The even address single-port memory 302 is disabled as the signal at the terminal CEN_EVEN goes high.

At time T2, the external write address ADD_{AB} at the write operation address input terminal AB is input. As the address ADD_{AB} is odd, the least significant bit ADD_{AB}[0] is digital one. Therefore, the selection signal of the multiplexer 305 becomes high, and the external write operation enable signal W_EN (which is low) at the terminal B of the multiplexer 305 is selected and sent to the write enable signal terminal WEN_ODD of the odd memory single-port memory 301 to enable write operation of the odd memory single-port memory 301.

In the example of FIG. 4C, as ADD_{AB}[0] is digital one and the external write operation enable signal W_EN is digital zero at time T2, therefore the output of the AND gate 451 is high. The selection signal for the multiplexer 307 is high, and the second address (ADD_{AB}/2), which is the quotient of the external write address ADD_{AB}, at the terminal A of the multiplexer 307 is selected and sent to the read/write address input terminal A_ODD of the odd address single-port memory 301. Simultaneously, at time T2, the data is input via the write operation data input terminal DB and sent to the data input terminal D_ODD of the odd address single-port memory 301. Therefore, the odd address single-port memory 301 in the dual-port memory 200 is enabled and performs the write operation on the odd address of the dual-port memory 200.

Similarly, a write operation may also be performed on the even address of the dual-port memory 200. The write operation performed on the even address of the dual-port memory 200 is similar to the write operation performed on the odd address and will not be repetitively described for purposes of brevity and clarity.

In one embodiment, the dual-port memory 200 may perform a read operation on an address and a write operation on another address with opposite parity simultaneously. That is, the read operation address and the write operation address have different parities. In one embodiment, when both of the external read operation enable signal R_EN and the write operation enable signal W_EN are low, the external write address ADD_{AB} at the write operation address input terminal AB is even, and the external read address ADD_{AA} at the read operation address input terminal AA is odd, then the write operation is performed on the even address of the dual-port memory 200, and the read operation is performed on the odd address of the dual-port memory 200.

As shown in FIG. 5, at time T3, both of the external read operation enable signal R_EN and the write operation enable signal W_EN are low, an odd external read address ADD_{AA} is input via the terminal AA, and an even external write address ADD_{AB} is input via the terminal AB. Thus, the least significant bit ADD_{AA}[0] is digital one, and the least significant bit ADD_{AB}[0] is digital zero. Referring to FIG. 4A, the outputs of the OR gates 424 and 426 are high, and the output of the AND gate 422 is high. Thus, the selection signal of the first multiplexer 304 becomes high, which selects the write operation enable signal W_EN (which is logic low) at the terminal B to output to the even address single-port memory 302. Therefore, the even address single-port memory 302 is enabled as the signal at the terminal CEN_EVEN goes low.

Referring to the selection signal generating circuit 410 in FIG. 4A, the outputs of the OR gates 413 and 415 are low, and the output of the AND gate 411 is low. Thus, the selection signal of the second multiplexer 303 becomes low, which selects the read operation enable signal R_EN (which is logic low) at the terminal A to output to the odd address single-port memory 301. Therefore, the odd address single-port memory 301 is enabled as the signal at the terminal CEN_ODD goes low.

Referring to FIG. 4B, as the least significant bit ADD_{AB}[0] is digital zero, the output of the NOT gate 442 is high, therefore, the selection signal of the multiplexer 306 becomes high, and the external write operation enable signal W_EN (which is low) at the terminal B of the multiplexer 306 is selected and sent to the write enable signal terminal WEN_EVEN of the even memory single-port memory 302 to enable write operation of the even memory single-port memory 302. The selection signal of the multiplexer 305 is low, and the signal mask (digital one) at the terminal A of the multiplexer 305 is selected and sent to the write enable signal terminal WEN_ODD of the odd memory single-port memory 301 to disable the write operation of the odd memory single-port memory 301.

As shown in FIG. 4C, as the external write operation enable signal W_EN at the write operation enable signal terminal CENB is low at time T3 and the ADD_{AB}[0] is digital zero, the output of the NOR gate 462 is high. Thus, the selection signal for the multiplexer 308 is high. Therefore, the second address (ADD_{AB}/2), which is the quotient of the external write address ADD_{AB} divided by two, at the terminal B of the multiplexer 308 is selected and sent to the read/write address input terminal A_EVEN of the even address single-port memory 302. Thus, the even address single-port memory 302 in the dual-port memory 200 is enabled and performs the write operation on the even address of the dual-port memory 200.

The output of the AND gate 451 in FIG. 4C is low, Therefore, the first address (ADD_{AA}/2), which is the quotient of the external read address ADD_{AA} divided by two, at the terminal A of the multiplexer 307 is selected and sent to the read/write address input terminal A_ODD of the odd address single-port memory 301. Thus, the odd address single-port memory 301 in the dual-port memory 200 is enabled and performs the read operation on the odd address of the dual-port memory 200.

The output multiplexer 309 outputs the data read from the odd address of the dual-port memory 200 in accordance with the selection signal provided by the DFF 472. Referring to FIG. 4D, as the least significant bit ADD_{AA}[0] of the external read address ADD_{AA} is digital one, the DFF 472 outputs digital one during the next clock cycle (time T4). Therefore, the data at the terminal B of the output multiplexer 309 is selected and output via the output terminal QA at time T4.

Similarly, the write operation can also be performed on the odd address of the dual-port memory 200 and read operation can be performed on the even address of the dual-port memory 200 simultaneously. The operations are similar to that described above, and will not be repetitively described for purposes of brevity and clarity

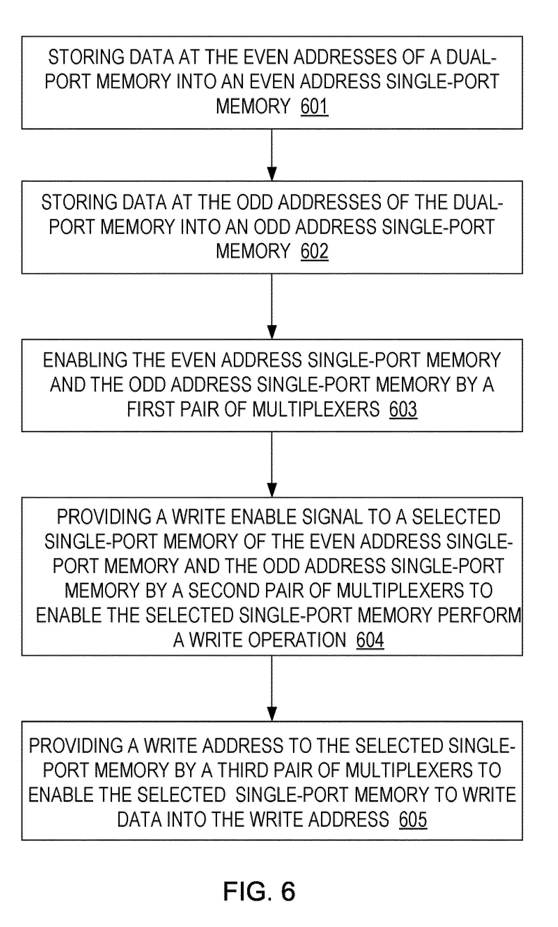

FIG. 6 shows a flowchart of operations performed by a dual-port memory 200, in accordance with one embodiment of the present teaching. Fig. 6 is described in combination with FIG. 3, FIG. 4A-4D and FIG. 5. Although specific steps are disclosed in FIG. 6, such steps are exemplary. That is, the present teaching is well suited to perform various other steps or variations of the steps recited in FIG. 6.

In step 601, data at the even addresses of the dual-port memory 200 is stored in an even address single-port memory 302. In step 602, data at the odd addresses of the dual-port memory 200 is stored in an odd address single-port memory 301. In one embodiment, the clock signal terminal CLK of the dual-port memory 200 is coupled to the clock signal terminal CLK_EVEN of the even address single-port memory 302 and the clock signal terminal CLK_ODD of the odd address single-port memory 301. The write operation data input terminal DB of the dual-port memory 200 is coupled to the write data input terminal D_EVEN of the even address single-port memory 302 and the write data input terminal D_ODD of the odd address single-port memory 301.

In this example, the external terminals of the dual-port memory 200 are coupled to the terminals of the even address single-port memory 302 and the odd address single-port memory 301 via multiple pairs of multiplexers. In step 603, a first pair of multiplexer 310 provides an enable signal to the even address single-port memory 302 and the odd address single-port memory 301. For example, the first pair of multiplexer 310 include a first multiplexer 304 and a second multiplexer 303 coupled to the chip enable signal terminals (CEN_EVEN and CEN_ODD) of the even address single-port memory 302 and the odd address single-port memory 301, respectively, and provide a chip enable signal to the even address single-port memory 302 and the odd address single-port memory 301 by selecting an external read operation enable signal R_EN or an external write operation enable signal W_EN of the dual-port memory 200.

In step 604, a second pair of multiplexer 320 provides a write operation enable signal to a selected single-port memory of the even address single-port memory 302 and the odd address single-port memory 301. For example, the second pair of multiplexer 320 include a third multiplexer 306 and a fourth multiplexer 305 coupled to the write operation enable signal terminals (WEN_EVEN and WEN_ODD) of the even address single-port memory 302 and the odd address single-port memory 301 and provide a write enable signal by selecting an external write operation enable signal W_EN and a signal mask, for example, digital one.

In step 605, a third pair of multiplexer 330 provides a write address to the selected single-port memory performing the write operation to enable the selected single-port memory to write data into the write address. For example, the third pair of multiplexer 320 includes a fifth multiplexer 308 and a sixth multiplexer 307 coupled to the read/write address input terminals (A_EVEN and A_ODD) of the even address single-port memory 302 and the odd address single-port memory 301 and provide the write address based on an external read address ADD_{AA} or an external write address ADD_{AB}.

In one embodiment, the third pair of the multiplexers 330 receives a first address (ADD_{AA}/2) which is the quotient of the external read address ADD_{AA} divided by two (that is, the external read address ADD_{AA} shifted right by one bit) and a second address (ADD_{AB}/2) which is the quotient of the external write address ADD_{AB} divided by two (that is, the external write address ADD_{AB} shifted right by one bit) and provides the second address as the write address to the selected single-port memory.

Moreover, the third pair of the multiplexers 330 provides the first address with a parity opposite to the second address as the read address to the other single-port memory to enable the other single-port memory to perform read operation. Therefore, the dual-port memory 200 may simultaneously perform the read operation on an address and the write operation on another address with parities opposite to each other. That is, the odd address single-port memory 301 performs the write operation on an odd address of the dual-port memory 200, and the even address single-port memory 302 performs the read operation on the even address of the dual-port memory simultaneously, or the odd address single-port memory 301 performs the read operation on an odd address of the dual-port memory 200, and the even address single-port memory 302 performs the write operation on the even address of the dual-port memory simultaneously.

In one embodiment, the data read from the even address single-port memory 302 or the odd address single-port memory 301 is output by an output multiplexer 309 during a next clock cycle. The selection signal of the output multiplexer 309 is determined by the parity of the external read address ADD_{AA}.

The selection signals of the multiplexers 303-308 may be determined by the parities of the external read address ADD_{AA} and the external write address ADD_{AB}. For example, the selection signals can be determined by a logical operation on the least significant bit (LSB) of the external read address ADD_{AA} and the least significant bit (LSB) of the external write address ADD_{AB}. In one embodiment, when the read operation and the write operation are performed simultaneously, the selection signals in each pair of the multiplexers are opposite to each other.

It should be understood that the foregoing multiplexers 303-308 may be implemented by multiple specific electronic devices such as AND gates, OR gates, independent multiplexers, or other suitable electronic devices.

By using two single-port memories, the dual-port memory of the present teaching can write data into an even address while reading data from an odd address and write data into an odd address while reading data from an even address. Moreover, by using the dual-port memory of the present teaching which has the same capacity and access speed with the conventional dual-port memory, the functions of the conventional dual-port memory are achieved, while the die size is reduced.

It will be understood that the foregoing disclosure is illustrative. The present teaching is not limited to the foregoing illustration. One of ordinary skill in the art should understand that various variations and modifications may be made therein without departing from the spirit and scope of the claims of the present teaching.

## Claims

1. A dual-port memory, comprising:
a first single-port memory configured to store data at an even address of the dual-port memory; and
a second single-port memory configured to store data at an odd address of the dual-port memory, wherein
the dual-port memory simultaneously performs a read operation to read data from the odd address and a write operation to write data into the even address, and
the dual-port memory simultaneously performs a read operation to read data from the even address and a write operation to write data into the odd address.

2. The dual-port memory of claim 1, further comprising:
a first pair of multiplexers comprising a first multiplexer and a second multiplexer and configured to provide a chip enable signal to at least one of the first single-port memory and the second single-port memory by selecting an external read operation enable signal and an external write operation enable signal,
wherein the first multiplexer is coupled to the first single-port memory, and the second multiplexer is coupled to the second single-port memory.

3. The dual-port memory of claim 2, further comprising:
a second pair of multiplexers comprising a third multiplexer and a fourth multiplexer and configured to provide a write enable signal to at least one of the first single-port memory and the second single-port memory by selecting the external write operation enable signal and a signal mask,
wherein the third multiplexer is coupled to the first single-port memory, and the fourth multiplexer is coupled to the second single-port memory.

4. The dual-port memory of claim 3, further comprising:
a third pair of multiplexers comprising a fifth multiplexer and a sixth multiplexer and configured to provide a read/write address to at least one of the first single-port memory and the second single-port memory based on an external read address and an external write address,
wherein the fifth multiplexer is coupled to the first single-port memory, and the sixth multiplexer is coupled to the second single-port memory.

5. The dual-port memory of claim 4, wherein the third pair of multiplexers provides a read address to at least one of the first single-port memory and the second single-port memory based on a quotient of the external read address divided by two; and
the third pair of multiplexers provides a write address to at least one of the first single-port memory and the second single-port memory based on a quotient of the external write address divided by two.

6. The dual-port memory of one of claims 3 to 5, wherein a pair of selection signals in each pair of said multiplexers are opposite to each other when the read operation and the write operation are performed simultaneously.

7. The dual-port memory of one of claims 2 to 6, wherein a selection signal of each multiplexer is determined by a parity of the external read address and the external write address.

8. The dual-port memory of claim 7, wherein the selection signal of each multiplexer is determined based on a least significant bit (LSB) of the external read address and a least significant bit (LSB) of the external write address.

9. The dual-port memory of one of claims 4 to 8, further comprising:
an output multiplexer configured to output data read from the first single-port memory or the second single-port memory.

10. The dual-port memory of claim 9, further comprising:
a flip-flop configured to provide a selection signal to the output multiplexer, wherein the selection signal is determined by a parity of the external read address and the external write address.

11. A method, comprising:
storing data at an even address of a dual-port memory into a first single-port memory;
storing data at an odd address of said dual-port memory into a second single-port memory;
enabling the first single-port memory and the second single-port memory by a first pair of multiplexers;
providing a write enable signal to a selected single-port memory of the first single-port memory and the second single-port memory by a second pair of multiplexers to enable the selected single-port memory to perform a write operation; and
providing a write address to the selected single-port memory by a third pair of multiplexers to enable the selected single-port memory to write data into the write address.

12. The method of claim 11, further comprising:
providing a read address to the other single-port memory of the first single-port memory and the second single-port memory by the third pair of multiplexers to enable the other single-port memory to perform a read operation and read data from the read address.

13. The method of claim 11 or 12, wherein the first pair of multiplexers comprise a first multiplexer and a second multiplexer, and are configured to provide a chip enable signal to the first single-port memory and the second single-port memory by selecting an external read operation enable signal and an external write operation enable signal to enable the first single-port memory and the second single-port memory,
wherein the first multiplexer is coupled to the first single-port memory, and the second multiplexer is coupled to the second single-port memory.

14. The method of claim 13, wherein the second pair of multiplexers comprise a third multiplexer and a fourth multiplexer, and are configured to provide the write enable signal to the selected single-port memory by selecting the external write operation enable signal and a signal mask,
wherein the third multiplexer is coupled to the first single-port memory, and the fourth multiplexer is coupled to the second single-port memory.

15. The method of claim 14, wherein the third pair of multiplexers comprise a fifth multiplexer and a sixth multiplexer, and are configured to provide the write address to the selected single-port memory and provide the read address to the other single-port memory based on an external read address and an external write address.

16. The method of claim 14 or 15, wherein the third pair of multiplexers provide the read address to the other single-port memory based on a quotient of the external read address divided by two; and
the third pair of multiplexers provide the write address to the selected single-port memory based on a quotient of the external write address divided by two.

17. The method of claim 14, 15 or 16, wherein a pair of selection signals in each pair of the multiplexers are opposite to each other when the read operation and the write operation are performed simultaneously.

18. The method of one of claims 14 to 17, wherein a selection signal of each multiplexer is determined by a parity of the external read address and the external write address.

19. The method of one of claims 14 to 18, wherein the selection signal of each multiplexer is determined based on a least significant bit (LSB) of the external read address and a least significant bit (LSB) of said external write address.

20. The method of one of claims 15 to 19, further comprising:
outputting data read from the other single-port memory by an output multiplexer.

21. The method of claim 20, further comprising:
providing a selection signal to the output multiplexer by a flip-flop, wherein the selection signal is determined by a parity of the external read address and the external write address.
